# EUROPÄISCHE PATENTSCHRIFT

(11) **EP 2 153 707 B1**
(45) Veröffentlichungstag und Bekanntmachung des Hinweises auf die Patenterteilung: **01.04.2015**
(21) Anmeldenummer: 08749798.8
(22) Anmeldetag: 28.04.2008
(51) Int. Cl.: H01L 23/31, H01L 23/538, H01L 23/00, H05K 1/02, H05K 3/46, H05K 1/18

(54) **VERFAHREN ZUR HERSTELLUNG EINER ELEKTRONISCHEN BAUGRUPPE**
METHOD FOR PRODUCING AN ELECTRONIC ASSEMBLY
PROCÉDÉ DE PRODUCTION D'UN COMPOSANT ÉLECTRONIQUE

(30) Priorität: 24.05.2007 DE 102007024189
(43) Veröffentlichungstag der Anmeldung: 17.02.2010
(73) Patentinhaber: Robert Bosch GmbH, 70442 Stuttgart (DE); Würth Elektronik GmbH & Co. KG, 74676 Niedernhall (DE); Fraunhofer-Gesellschaft zur Förderung der angewandten Forschung e.V., 80686 München (DE)
(72) Erfinder: SCHAAF, Ulrich, 73667 Kaisersbach (DE); KUGLER, Andreas, 73553 Alfdorf (DE); BECKER, Karl-Friederich, 10999 Berlin (DE); NEUMANN, Alexander, 10437 Berlin (DE); KOSTELNIK, Jan, Dr., 74592 Kirchberg An Der Jagst (DE)
(74) Vertreter: Hörschler, Wolfram Johannes
(86) Internationale Anmeldenummer: PCT/EP2008/055175
(87) Internationale Veröffentlichungsnummer: WO 2008/141898

(56) Entgegenhaltungen:
- EP-A- 1 729 552
- WO-A-2005/008733
- WO-A-2006/056643
- US-A1- 2002 117 743
- US-A1- 2003 169 575
- US-A1- 2004 001 324
- US-A1- 2006 170 098

## Beschreibung

### Stand der Technik

Die Erfindung betrifft ein Verfahren zur Herstellung einer elektronischen Baugruppe gemäß dem Oberbegriff des Anspruchs 1.

### Verfahren zur Herstellung elektronischer Baugruppen sind z.B. aus den Dokumenten WO 2005/008733 A (2005-01-27), WO 2006/056643 A (2006-06-01), oder US 2003/169575 A1 (2003-09-11) bekannt.

Um elektronische Bauelemente, die in elektronischen Baugruppen auf Leiterplatten eingesetzt werden, verkapseln zu können und um die Flächennutzung auf dem elektronischen Schaltungsträger zu steigern, ist es bekannt, die elektronischen Bauelemente in der Leiterplatte aufzunehmen. Hierdurch ist ein Schutz der elektronischen Bauelemente möglich. Aus US-B 6,512,182 ist es zum Beispiel bekannt, in ein Leiterplattensubstrat Aufnahmen einzufräsen, in welche die elektronischen Bauelemente eingelegt werden. Nach dem Einlegen der elektronischen Bauelemente werden die Aufnahmen ausgefüllt, anschließend geglättet und überlaminiert. Durch das Einbetten der elektronischen Bauelemente lässt sich eine glatte Oberfläche der elektronischen Baugruppe erzielen.

Nachteil dieser Baugruppe ist es, dass zunächst Aufnahmen in das Leiterplattensubstrat eingefräst werden, in welches die elektronischen Bauelemente eingesetzt werden. Eine exakte Positionierung der elektronischen Bauelemente ist auf diese Weise nur schwer möglich.

Aus DE-A 10 2005 003 125 ist ein Verfahren zur Herstellung einer elektrischen Schaltung bekannt, wobei die Schaltung elektrische Bauelemente aufweist, die mechanisch durch eine Vergussmasse miteinander verbunden sind. Auf mindestens einer Seite der Vergussmasse ist mindestens eine Schicht Leiterbahnen vorgesehen, die die Bauelemente elektrisch miteinander verbindet. Zur Herstellung der Schaltung werden die Bauelemente auf einer Trägerfolie aufgebracht und anschließend mit einer Vergussmasse umgossen. Daran anschließend wird die Trägerfolie entfernt, und auf der Seite, auf der die Bauelemente mit der Trägerfolie verbunden waren, werden eine oder mehrere Schichten von Leiterbahnen aufgebracht, die die Bauelemente elektrisch miteinander verbinden.

Nachteil dieses Verfahrens ist es, dass die Trägerfolie rückstandsfrei entfernt werden muss, um eine funktionsfähige Verschaltung der elektrischen Schaltung zu erzielen.

### Offenbarung der Erfindung

### Vorteile der Erfindung

Die Erfindung betrifft ein Verfahren zur Herstellung einer elektronischen Baugruppe (21), umfassend mindestens ein elektronisches Bauelement (9), das auf einer Leiterplatte (23) befestigt ist, sowie mindestens eine Leiterbahnstruktur (15, 27), mit der das mindestens eine elektronische Bauelement (9) kontaktiert wird, folgende Schritte umfassend:
(a) Befestigen des mindestens einen elektronischen Bauelementes (9) auf einer isolierenden Schicht (5) einer leitfähigen Folie (1), wobei die aktive Seite des mindestens einen elektronischen Bauelements (9) in Richtung der leitfähigen Folie (1) weist,
(b) Auflaminieren der leitfähigen Folie (1) mit dem mindestens einen daran befestigten elektronischen Bauelement (9) auf einen Leiterplattenträger (13), wobei das mindestens eine elektronische Bauelement (9) in Richtung des Leiterplattenträgers (13) weist,
(c) Ausbilden einer Leiterbahnstruktur (15) durch Strukturieren der leitfähigen Folie (1) und Ankontaktieren des mindestens einen elektronischen Bauelements (9),
dadurch gekennzeichnet, dass erste elektronische Bauteile (9) vorgesehen sind, welche für eine Ankontaktierung mit der Leiterbahnstruktur (15) kleine Durchgänge (17) in der isolierenden Schicht (5) benötigen, und zweite elektronische Bauteile (9) vorgesehen sind, welche größere Durchgänge (17) in der isolierenden Schicht (5) benötigen, und die ersten elektronischen Bauteile (9) weiter in die isolierende Schicht (5) eingedrückt werden als die zweiten elektronischen Bauteile (9).

Der Vorteil, die elektronischen Bauelemente, die für die Ankontaktierung mit der Leiterbahnstruktur kleinere Durchgänge in der isolierenden Schicht benötigen, weiter in die isolierende Schicht einzudrücken als elektronische Bauteile, die größere Durchgänge in der isolierenden Schicht benötigen, liegt darin, dass das für die Durchgänge optimale Aspektverhältnis, das heißt Verhältnis von Länge zu Durchmesser des Durchganges, eingestellt werden kann. Hierdurch lassen sich auch empfindliche elektronische Bauteile, wie sie zum Beispiel in der Hochfrequenztechnologie benötigt werden, derart in die elektronische Baugruppe integrieren, dass ein sicherer und störungsfreier Betrieb möglich ist.

Durch das Befestigen des mindestens einen elektronischen Bauelementes auf der isolierenden Schicht der leitfähigen Trägerfolie lassen sich die elektronischen Bauelemente exakt positionieren. Beim anschließenden Auflaminieren der leitfähigen Trägerfolie mit dem mindestens einen daran befestigten elektronischen Bauelement auf einen Leiterplattenträger, wobei das mindestens eine elektronische Bauelement in Richtung des Leiterplattenträgers weist, wird das mindestens eine elektronische Bauelement vom Leiterplattenträger umschlossen. Hierdurch wird das Bauelement vollständig gekapselt.

In einer bevorzugten Ausführungsform wird das mindestens eine elektronische Bauelement nach dem Befestigen auf der leitfähigen Trägerfolie von einer Polymermasse umschlossen. Das Umschließen des mindestens einen elektronischen Bauelementes mit der Polymermasse führt zu einem zusätzlichen Schutz des Bauelementes. Hierdurch wird auch bei empfindlichen Bauelementen die Gefahr einer Beschädigung deutlich gemindert.

Die Polymermasse, mit der das mindestens eine elektronische Bauelement umschlossen wird, weist zum Beispiel eine flüssige Harzmatrix auf. Diese wird um das elektronische Bauelement gegossen und anschließend ausgehärtet. Die derart aufgebrachte Polymermasse ist zum Beispiel ein Epoxidharz.

Alternativ ist es auch möglich, dass die Polymermasse, mit der das mindestens eine elektronische Bauelement umschlossen wird, zum Beispiel eine Niederdruckpressmasse, beispielsweise eine Epoxy-Niederdruckpressmasse ist. Die Niederdruckpressmasse wird zum Beispiel durch ein Spritzpressverfahren aufgebracht. In der Polymermasse können zusätzlich Platzhalter zum Beispiel für dickere Dielektrika freigehalten werden. Diese können jedoch auch als Einlegeteile beim Umschließen des mindestens einen elektronischen Bauelementes mit der Polymermasse mit umschlossen werden.

In einer bevorzugten Ausführungsform enthält die isolierende Schicht der leitfähigen Folie mindestens ein Flüssigkristall-Polymer. Aufgrund der thermoplastischen und teilkristalllinen Eigenschaften des Flüssigkristall-Polymers (LCP) ist es möglich, die leitfähige Folie an einen gewünschten Ausdehnungskoeffizienten anzupassen. Das Anpassen an den gewünschten Ausdehnungskoeffizienten erfolgt durch die Art, den Anteil, die Anordnung und die Konzentration des kristallinischen Anteils des Polymers.

Wenn die elektronischen Bauteile unterschiedlich tief in die isolierende Schicht der leitfähigen Folie eingedrückt werden, dann erfolgt das Eindrücken in die isolierende Schicht der leitfähigen Folie vorzugsweise so weit, dass die Durchkontaktierungen, mit denen die elektronischen Bauteile an die Leiterbahnstruktur angeschlossen werden, ein Aspektverhältnis aufweisen, das größer als 1 ist. Besonders bevorzugt liegt das Aspektverhältnis im Bereich von 1 bis 3. Unter Aspektverhältnis wird das Verhältnis von Länge zu Durchmesser der Bohrung verstanden.

Das Befestigen des mindestens einen elektronischen Bauelementes erfolgt vorzugsweise durch Aufkleben. Hierzu ist es bevorzugt, dass die leitfähige Trägerfolie eine Klebeschicht aufweist. Die Klebeschicht bildet dabei vorzugsweise gleichzeitig die isolierende Schicht. Die leitfähige Trägerfolie ist dabei zum Beispiel eine selbstklebende leitfähige Trägerfolie. Das Aufkleben kann durch Heiß- und Druckprozesse erfolgen. Dies ist zum Beispiel auch ein Heißklebeprozess. Alternativ ist es selbstverständlich auch möglich, dass das Befestigen des mindestens einen elektronischen Bauelementes durch Aufkleben auf die isolierende Schicht der leitfähigen Folie mit einem elektrische nicht leitfähigen Klebstoff erfolgt. Derartige Klebstoffe sind zum Beispiele übliche Polymerklebstoffe.

Die leitfähige Trägerfolie, die eingesetzt wird, ist zum Beispiel eine Kupferfolie, wie sie auch als RCC-Material aus der Leiterplattentechnik bekannt ist. Weitere geeignete Folien sind beispielsweise LCP-Folien oder FEP-Folien. Besonders bevorzugt sind LCP-Folien, da bei diesen aufgrund der wie bereits oben erwähnten teilkristallinen und thermoplastischen Eigenschaften der Ausdehnungskoeffizient einstellbar ist. Als Metall eignen sich neben Kupfer zum Beispiel auch Aluminium, Nickel oder Nickellegierungen, zum Beispiel NiPd, NiAu, NiPdAu.

In einer bevorzugten Ausführungsform werden vor dem Aufbringen des mindestens einen elektronischen Bauelementes auf die leitfähige Trägerfolie in Schritt (a) Justagemarken in die leitfähige Trägerfolie eingebracht. Die Justagemarken sind zum Beispiel Löcher oder Sacklöcher mit einem beliebigen Querschnitt. Diese können zum Beispiel durch Ätzen, Stanzen oder Bohren in die leitfähige Trägerfolie eingebracht werden. Die Justagemarken werden dabei auf der dem mindestens einen elektronischen Bauelement gegenüberliegenden Seite der leitfähigen Trägerfolie angebracht. Durch die Justagemarken lässt sich auch nach dem Umschließen des mindestens einen elektronischen Bauelementes mit der Polymermasse beziehungsweise nach dem Auflaminieren der leitfähigen Trägerfolie auf den Leiterplattenträger die genaue Position des mindestens einen elektronischen Bauelementes bestimmen. Dies ist für die Kontaktierung des mindestens einen elektronischen Bauelementes erforderlich. Alternativ eignen sich als Justagemarken zum Beispiel auch Bauelemente, mit denen die leitfähige Folie bestückt ist. An den Stellen, an denen die Bauelemente angeordnet sind, wird die leitfähige Folie vorzugsweise freigebohrt oder geröntgt, um die Bauelemente zu erkennen. Daneben können die Justagemarken selbstverständlich auch jede andere, dem Fachmann bekannte Form aufweisen.

An den Positionen, an denen das mindestens eine elektronische Bauelement mit der leitfähigen Trägerfolie elektrisch kontaktiert werden soll, werden vorzugsweise Löcher eingebracht. Zur Kontaktierung der leitfähigen Trägerfolie mit dem mindestens einen elektronischen Bauelement werden die Löcher zum Beispiel metallisiert. Das Einbringen der Löcher erfolgt zum Beispiel durch Laserbohren. Die Positionen, an denen die Löcher eingebracht werden, werden anhand der Justagemarken bestimmt.

Das Metallisieren der Löcher, um einen Kontakt des elektronischen Bauelementes mit der leitfähigen Trägerfolie zu erzielen, erfolgt nach dem Fachmann bekannten Verfahren. Das Metallisieren kann zum Beispiel durch stromlose Metallabscheidung erfolgen. Die stromlose Metallabscheidung ist ein übliches Verfahren, welches in der Leiterplattenherstellung eingesetzt wird. Das Metallisieren der Löcher erfolgt vorzugsweise mit Kupfer. Alternativ eignen sich jedoch auch Aluminium, Nickel und nickelhaltige Legierungen, zum Beispiel NiPd, NiAu und NiPdAu.

Weitere Leiterbahnen lassen sich zum Beispiel dadurch aufbringen, dass auf die in (c) strukturierte leitfähige Trägerfolie weitere Lagen, die Leiterbahnen enthalten, aufgebracht werden. Hierzu wird vorzugsweise zunächst ein Dielektrikum aufgebracht, durch welches die in Schritt (c) ausgebildeten Leiterbahnen abgedeckt werden. Gleichzeitig erfolgt hierdurch eine Isolierung der Leiterbahnen, damit kein unerwünschter elektrischer Kontakt mit den Leiterbahnen der nachfolgend angebrachten Schicht erfolgt. Daran anschließend werden auf das Dielektrikum nach dem Fachmann bekannten Verfahren weitere Leiterbahnen aufgebracht. Die weiteren Lagen, die Leiterbahnen enthalten, können alternativ auch durch Aufbringen weiterer leitfähiger Folien auf die erste Lage und anschließendem Strukturieren der Folie zur Ausbildung von Leiterbahnen hergestellt werden.

Wenn die leitfähige Folie aufgespreizt wird, bevor die weiteren Lagen, die Leiterbahnen enthalten, aufgebracht werden, ist es möglich, die Leiterbahnen der weiteren Lagen durch bekannte Prozesse, zum Beispiel photolithographische Verfahren oder ähnliche, zu strukturieren. Da durch das Aufspreizen die Leiterbahnstruktur der ersten Lage vergrößert wird, braucht der Prozess zur Herstellung der weiteren Leiterbahnstrukturen nicht mehr genauso präzise sein wie der Prozess zur Herstellung der ersten Leiterbahnstruktur. Bei der Aufspreizung wird die Anschlussfläche der ersten Leiterbahnstruktur nach außen gelegt. Dies erfolgt zum Beispiel durch eine Vergrößerung der Struktur beim Ätzprozess.

Wenn die Leiterbahnstruktur der ersten Lage vor dem Auftragen der weiteren Lagen aufgespreizt wird, ist es bevorzugt, wenn die Ankontaktierung auf die Landeflächen der elektronischen Bauelemente versetzt erfolgt. Vorteil der versetzten Ankontaktierung ist zum Beispiel, dass Bauelemente mit sehr kleinen Rastermaßen gebohrt werden können und die Bohrungen der oberen Lagen größer gewählt werden können.

Um eine engere Bestückung zu erzielen, ist es weiterhin möglich, dass auf die elektronischen Bauelemente weitere Bauelemente in Stapeltechnik befestigt werden. Dies erfolgt im Allgemeinen derart, dass die Anschlusskontaktierungen der elektronischen Bauelemente voneinander weg weisen. Das Aufkleben der weiteren elektronischen Bauteile auf die Bauteile ist zum Beispiel mit Hilfe eines Die-Attach-Films möglich.

Um beim Betrieb der elektronischen Baugruppe entstehende Wärme abzuführen, ist es bevorzugt, dass das mindestens eine elektronische Bauelement nach dem Auflaminieren der leitfähigen Trägerfolie auf den Leiterplattenträger in Schritt (b) auf der von der leitfähigen Trägerfolie wegweisenden Seite mit einem Metallkern kontaktiert wird, so dass der Metallkern nach dem Auflaminieren auf den Leiterplattenträger ebenfalls in der Leiterplatte integriert ist. Das elektronische Bauelement gibt dann im Betrieb Wärme an den Metallkern ab, über welchen diese nach außen abgegeben werden kann. Weiterhin ist es auch möglich, wenn die elektronischen Bauelemente von der Polymermasse umschlossen sind, dass in der Polymermasse ein Metallkern zur Wärmeabfuhr aufgenommen ist. Das eingesetzte Metall ist vorzugsweise ein gut wärmeleitendes Metall, zum Beispiel Kupfer. In einer Ausführungsform ist der Metallkern, über welchen Wärme abgeführt werden kann, im Leiterplattenträger integriert.

Vorteil des erfindungsgemäßen Verfahrens ist es, dass durch das Umschließen des mindestens einen elektronischen Bauelementes mit der Polymermasse bzw. durch das Einbetten des elektronischen Bauelementes in den Leiterplattenträger eine kostengünstige Verkapselung von passiven und aktiven elektronischen Bauelementen erzielt wird. Zudem ist die elektronische Baugruppe durch die komplette Kapselung empfindlicher Bauelemente sehr zuverlässig. Ein weiterer Vorteil der Kapselung ist es, dass hierdurch ein Höhenausgleich ermöglicht wird, wenn unterschiedlich hohe Bauelemente verwendet werden.

Weiterhin werden durch das erfindungsgemäße Verfahren risikoreiche Mischtechniken in der Fertigung, zum Beispiel Löten, Kleben und Drahtbonden, vermieden. Bei Einsatz der elektronischen Baugruppe in Hochfrequenztechnik, das heißt wenn das elektronische Bauelement ein Hochfrequenzbauelement ist, werden reproduzierbare Hochfrequenzübergänge durch die planare Ausgangsstruktur, die durch das erfindungsgemäße Verfahren erzielt wird, erreicht.

Das erfindungsgemäße Verfahren erlaubt es auch, gegebenenfalls notwendige Kühlkörper auf Leistungshalbleitern zu integrieren. Diese können zum Beispiel das elektronische Bauelement auf der der leitfähigen Trägerfolie abgewandten Seite kontaktieren. Alternativ ist es auch möglich, dass diese zum Beispiel in die Polymermasse eingebetet werden, mit der das mindestens eine elektronische Bauelement umschlossen wird.

Durch das erfindungsgemäße Verfahren lässt sich weiterhin eine kostengünstige Verdrahtung und Verkapselung erzielen durch den Einsatz von Prozessen auf vielen Modulen gleichzeitig. Insbesondere ist es dann, wenn die erste Lage vor Aufbringen weiterer Lagen von Leiterbahnstrukturen aufgespreizt wird, möglich, einen gesamten Großnutzen auf einmal zu bearbeiten.

### Kurze Beschreibung der Zeichnungen

Ausführungsbeispiele der Erfindung sind in den Zeichnungen dargestellt und in der nachfolgenden Beschreibung näher erläutert.

Es zeigen:
- Figur 1: eine leitfähige Folie mit darauf angebrachten elektronischen Bauelementen,
- Figur 2: eine leitfähige Folie mit darauf angebrachten von einer. Polymermasse umschlossenen elektronischen Bauteilen,
- Figur 3: eine auf einen Leiterplattenträger auflaminierte leitfähige Folie mit elektronischen Bauelementen,
- Figur 4: den Leiterplattenträger aus Figur 3 mit einer ausgebildeten Leiterplattenstruktur und ankontaktierten elektronischen Bauelementen,
- Figur 5: eine erfindungsgemäße elektronische Baugruppe,
- Figur 6: eine erfindungsgemäße elektronische Baugruppe mit einer mechanischen Einlage,
- Figur 7: eine erfindungsgemäße elektronische Baugruppe mit Bauelementen in zwei Ebenen,
- Figur 8: eine erfindungsgemäße elektronische Baugruppe mit integrierten Metallkernen,
- Figur 9.1: eine schematische Darstellung einer versetzten Ankontaktierung in Draufsicht,
- Figur 9.2: eine schematische Darstellung der versetzten Ankontaktierung gemäß Figur 9.1 in einer Schnittdarstellung,
- Figur 10: mehrere Baugruppen auf einer leitfähigen Folie.

### Ausführungsformen

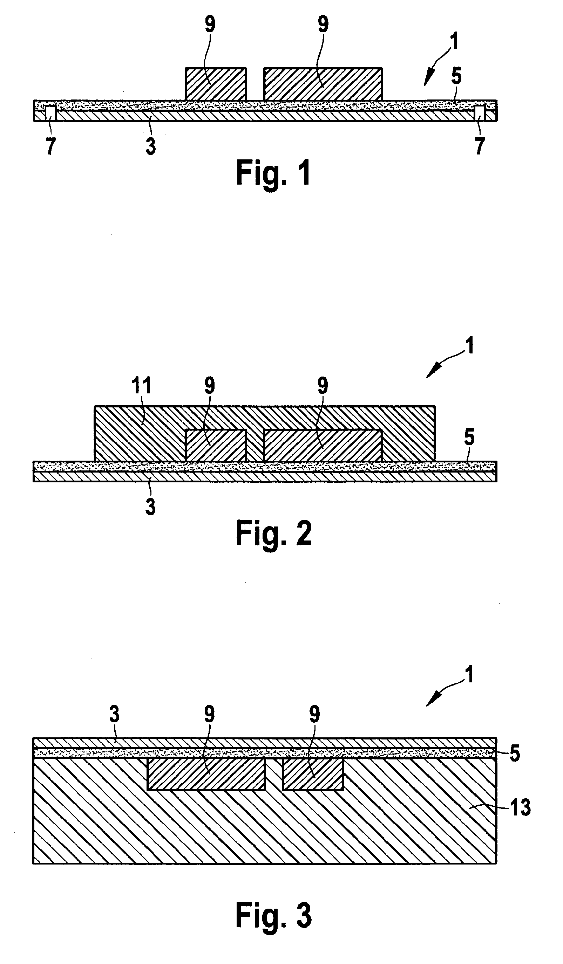

In Figur 1 ist eine leitfähige Trägerfolie mit darauf befestigten elektronischen Bauelementen dargestellt.

Eine leitfähige Trägerfolie 1 umfasst eine leitfähige Schicht 3 und eine isolierende Schicht 5. Die isolierende Schicht 5 ist vorzugsweise eine Klebschicht oder ein Thermoplast, auf die elektronische Bauelemente 9 aufgebracht werden können. Auf der Seite der leitfähigen Trägerfolie 1, auf der sich die leitfähige Schicht 3 befindet, werden Justagemarken 7 eingebracht. Die Justagemarken 7 können zum Beispiel durch Ätzen, Stanzen, Bohren, beispielsweise Laserbohren, in die leitfähige Trägerfolie 1 eingebracht werden. Weiterhin ist es auch möglich, dass die Justagemarken auch mit der leitfähigen Trägerfolie 1 verbundene Bauelemente sind, die freigebohrt oder durch Röntgenmikroskopie detektiert werden. Auch jede andere, dem Fachmann bekannte Form für Justagemarken ist möglich.

Die leitfähige Schicht 3 ist vorzugsweise eine Metallschicht. Besonders bevorzugt als Metall ist Kupfer. Alternativ eignen sich für die Metallschicht auch Aluminium oder Nickel beziehungsweise Nickellegierungen.

Auf die isolierende Schicht 5 werden in einem zweiten Schritt nach dem Einbringen der Justagemarken 7 die elektronischen Bauelemente 9 aufgebracht. Neben den elektronischen Bauelementen 9 ist es auch möglich, dass auf die isolierende Schicht 5 der leitfähigen Trägerfolic 1 mechanische Bauelemente aufgebracht werden. Die elektronischen Bauelemente 9 beziehungsweise mechanischen Bauelemente, die auf die isolierende Schicht 5 der leitfähigen Trägerfolie 1 aufgebracht werden, sind übliche Bauelemente, wie sie im Leiterplattenbau eingesetzt werden. Hierbei handelt es sich zum Beispiel um Chips, Prozessoren, Hochfrequenzbauteile, SMD-Komponenten, Antennenmodule, Kühlkörper, MEMS oder MOEMS.

Das Aufbringen der elektronischen Bauelemente 9 beziehungsweise mechanischen Bauelemente erfolgt vorzugsweise durch Aufkleben auf die isolierende Schicht 5. Hierbei werden die elektronischen Bauelemente 9 so auf der isolierenden Schicht 5 der leitfähigen Trägerfolie 1 platziert, wie die elektronischen Bauelemente 9 später in der elektrischen Schaltung angeordnet sein sollen. Es können auf einzelne oder alle elektronischen Bauelemente 9 Kühlkörper aufgebracht werden, um eine erhöhte Wärmeabfuhr während des Betriebes der elektronischen Bauelemente 9 zu gewährleisten. Die optional vorsehbaren Kühlkörper werden hierbei auf der Seite der elektronischen Bauelemente 9 aufgesetzt, die der leitfähigen Trägerfolie I abgewandt ist.

Um für eine spätere Ankontaktierung der elektronischen Bauelemente 9 an die leitfähige Schicht 3, aus der eine Leiterbahnstruktur gefertigt wird, ein optimales Aspektverhältnis zu erreichen, ist es bevorzugt, wenn die elektronischen Bauelemente 9 unterschiedlich tief in die isolierende Schicht 5 eingedrückt werden. Die Eindrücktiefe ist davon abhängig, wie groß die Pads sind, mit denen die elektronischen Bauteile 9 kontaktiert werden. Ein Bauteil mit großen Pads muss weniger weit eingedrückt werden als ein elektronisches Bauteil 9 mit kleinen Pads. Dies liegt daran, dass große Pads gröber angebohrt werden können als kleine Pads. Für kleine Pads sind feinere Bohrungen notwendig. Insbesondere bei Hochfrequenz-Anwendungen ist es vorteilhaft, wenn das Aspektverhältnis der Bohrungen im Bereich von 1 bis 3 liegt. Das heißt, dass die Bohrungen maximal eine Tiefe aufweisen, die dreimal so groß ist wie der Durchmesser der Bohrung. Die unterschiedliche Eindrücktiefe der elektronischen Bauteile 9 in die isolierende Schicht 5 wird zum Beispiel durch die Kraft, mit der die elektronischen Bauteile 9 auf die isolierende Schicht 5 aufgedrückt werden, die Temperatur und die Haltezeit, bei der die elektronischen Bauelemente 9 aufgeklebt werden, eingestellt. Zusätzlich zu der isolierenden Schicht 5 ist es möglich, dass ein weiterer Klebstoff verwendet wird, mit dem die elektronischen Bauteile 9 auf der isolierenden Schicht 5 befestigt werden. Der weitere Klebstoff ist dabei vorzugsweise ebenfalls elektrisch isolierend.

Um eine Kapselung von empfindlichen elektronischen Bauelementen 9 zu erzielen, ist es möglich, diese mit einer Polymermasse 11 zu umschließen. Dies ist in Figur 2 dargestellt. Die Polymermasse 11 ist zum Beispiel eine Epoxy-Niederdruckpressmasse. In die Polymermasse 11 können, wenn erforderlich, zum Beispiel Platzhalter für dickere Dielektrika, die zum Beispiel für Antennen oder Kühlkörper verwendet werden, umspritzt werden. Das Umhüllen mit der Polymermasse 11 erfolgt zum Beispiel mittels eines Spritzpressverfahrens. Alternativ ist es auch möglich, die Umhüllung mit der Polymermasse 11 durch einen so genannten Glop Top-Prozess zu erzeugen. Hierzu werden die elektronischen Bauelemente 9 mit einer flüssigen Harzmasse, zum Beispiel einem Epoxidharz, umgossen. Die flüssige Harzmasse wird anschließend ausgehärtet.

Die Platzhalter können zum Beispiel als Vertiefungen oder Wannen ausgeformt sein.

Neben dem Spritzpressverfahren ist jedoch auch jedes andere, dem Fachmann bekannte Verfahren einsetzbar, mit dem sich die elektronischen Bauelemente 9 mit der Polymermasse 11 ummanteln lassen. Zusätzlich hat die Ummantelung mit der Polymermasse 11 den Vorteil, dass ein Höhenausgleich bei Bauelementen 9 mit unterschiedlicher Dicke möglich ist. Dies ist vorteilhaft für den nachfolgenden Laminierprozess. Bauteile können zudem auf abzichbarer Folie vorverkapselt werden und nach Abziehen der Folie auf die Trägerfolie 1 montiert werden.

Nach dem Aufbringen der elektronischen Bauelemente 9 auf die leitfähige Trägerfolie 1 oder, wenn die elektronischen Bauelemente 9 von der Polymermasse umschlossen werden sollen, nach dem Umschließen der elektronischen Bauelemente 9 mit der Polymermasse 11, wird die leitfähige Folie 1 vorzugsweise auf Leiterplattenzuschnitt zugeschnitten.

Nach dem Zuschneiden wird die leitfähige Folie 1 mit den darauf angebrachten elektronischen Bauelementen 9 und gegebenenfalls weiteren mechanischen Bauelementen, die hier nicht dargestellt sind, auf einen Leiterplattenträger 13 auflaminiert. Dies ist in Figur 3 dargestellt. Bei der hier dargestellten Ausführungsvariante ist die leitfähige Folie 1 mit den elektronischen Bauelementen 9 auf den Leiterplattenträger 13 auflaminiert worden, ohne dass die elektronischen Bauelemente 9 von der Polymermasse 11 umschlossen worden sind. Erfindungsgemäß wird aber auch die in Figur 2 dargestellte Ausführungsform, bei der die elektronischen Bauelemente 9 von der Polymermasse 11 umschlossen sind, auf den Leiterplattenträger 13 auflaminiert. Das Auflaminieren erfolgt dabei nach dem Fachmann bekannten Verfahren. Der Leiterplattenträger 13 wird erfindungsgemäß derart auf die leitfähige Folie 1 auflaminiert, dass die elektronischen Bauelemente 9 oder die von der Polymermasse 11 umschlossenen elektronischen Bauelemente 9 vom Leiterplattenträger 13 umschlossen werden. Hierzu wird der Leiterplattenträger 13 auf der Seite auf die leitfähige Folie 1 auflaminiert, auf der auch die elektronischen Bauelemente 9 angebracht sind.

Im Allgemeinen wird hierzu bei Bauelementen 9, deren Bauteildicke größer als 0,1 mm ist, zunächst ein glasfaserverstärktes und an den Stellen der Bauelemente 9 vorgebohrtes ausgehärtetes Leiterplattenmaterial auf die Folie aufgelegt. Hierauf wird ein Prepreg und gegebenenfalls ein weiteres ausgehärtetes Leiterplattenmaterial aufgelegt. Dieser Stapel wird dann in einem Laminierprozess verpresst. Das ausgehärtete Leiterplattenmaterial ist üblicherweise ein glasfaserverstärktes Epoxidharz. Es ist jedoch auch jedes andere geeignete, dem Fachmann bekannte Material einsetzbar. Als Prepreg wird im Allgemeinen ebenfalls ein Epoxidharz eingesetzt. Dieses ist jedoch noch nicht vollständig ausgehärtet. Durch Aufbringen von Druck und einer erhöhten Temperatur härtet das Prepreg vollständig aus, wodurch sich dieses mit dem ausgehärteten Leiterplattenmaterial verbindet. Der Verbund aus Prepreg und ausgehärtetem Leiterplattenmaterial bildet den Leiterplattenträger 13.

Um ein Verrutschen oder einen Verzug der elektronischen Bauteile beim Laminierprozess zu vermeiden, wird das Auflaminieren des Leiterplattenträgers 13 in einem vorgegebenen engen Temperaturbereich durchgeführt. Hierzu wird die Temperatur für den Laminiervorgang zum Beispiel auf einen Bereich von ± 5 K eingestellt. Die Temperatur für das Laminieren ist dabei niedriger als die Schmelztemperatur des Klebstoffes, mit welchem die elektronischen Bauelemente 9 auf der leitfähigen Folie 1 befestigt sind. Hierdurch wird das Verrutschen vermieden. Alternativ ist es bevorzugt, dass der Klebstoff, mit welchem die elektronischen Bauelemente 9 auf der leitfähigen Folie 1 befestigt sind, bereits so weit ausgehärtet ist, dass diese nicht mehr verrutschen oder verziehen können. Dies ist zum Beispiel bei Duromeren, die auch bei höherer Temperatur nicht mehr weich werden, durchführbar. Derartige Duromeren werden zum Beispiel bei Einsatz von RCC-Folien als leitfähige Folie 1 eingesetzt. Bei LCP-Folien ist keine separate Kleberschicht vorgesehen. Jedoch erfolgt die Klebung bei einer Temperatur, die oberhalb der Temperaturen bei allen nachfolgenden Verfahrensschritten liegt.

Nach dem Auflaminieren der leitfähigen Folie 1 mit den elektronischen Bauelementen 9 beziehungsweise mit den gegebenenfalls von der Polymermasse 11 umschlossenen elektronischen Bauelementen 9 auf den Leiterplattenträger 13 werden an den Anschlussstellen der elektronischen Bauelemente 9 Löcher 17 in die Trägerfolie 1, umfassend die leitfähige Schicht 3 und die isolierende Schicht 5, eingebracht. Die richtige Positionierung der Löcher 17 kann durch die anfangs eingebrachten Justagemarken 7 ermittelt werden. Hierdurch ist es möglich, genau an den Positionen, an denen sich die elektrischen Anschlüsse der elektronischen Bauelemente 9 befinden, die Löcher 17 zu erzeugen.

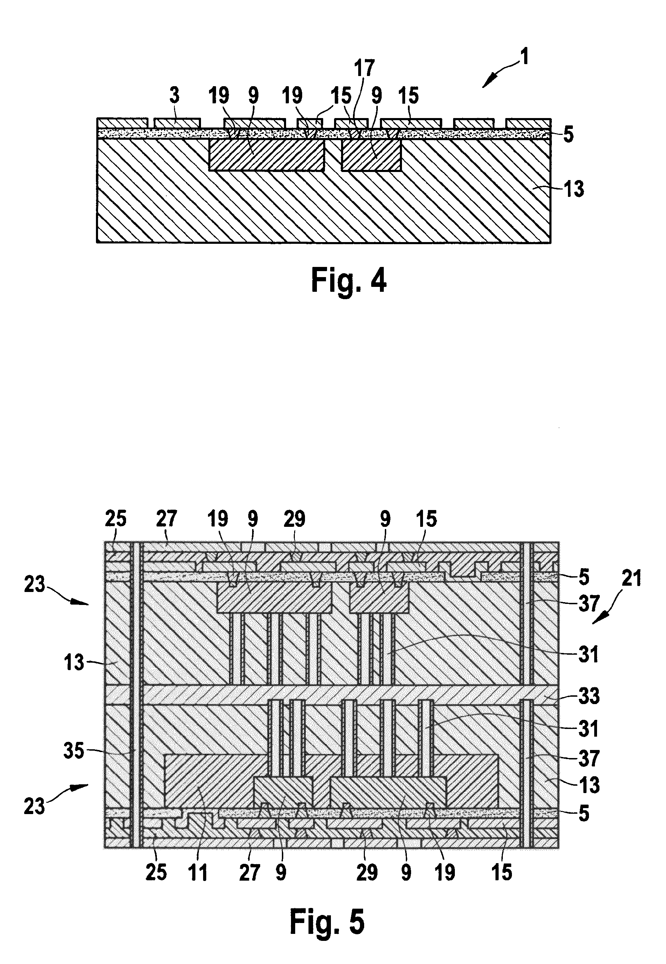

Üblicherweise werden gleichzeitig mit dem Einbringen der Löcher 17 zur Kontaktierung der elektronischen Bauelemente 9 mit der leitfähigen Schicht 3 oder direkt im Anschluss daran Kühlkanäle 31, wie sie in Figur 5 dargestellt sind, in den Leiterplattenträger 13 gebohrt. Hierzu wird zum Beispiel ein Laserbohrverfahren eingesetzt. Wenn auch die Löcher 17 durch ein Laserbohrverfahren erzeugt werden, wird für die Kühlkanäle 31 vorzugsweise ein zweiter Laser eingesetzt. Es können aber auch andere Löcher 17 und Kühlkanäle 31 mit dem gleichen Laser gebohrt werden.

Durch Metallisierung werden die elektronischen Bauelemente 9 mit der leitfähigen Schicht 3 elektrisch kontaktiert. Dies ist in Figur 4 dargestellt. Zur Metallisierung wird durch dem Fachmann bekannte Verfahren, zum Beispiel durch stromlose Metallabscheidung, Metall 19 in den Löchern 17 abgeschieden. Dieses Metall verbindet die Anschlüsse der elektronischen Bauelemente 9 mit der Leiterbahnstruktur 15. Ein elektrischer Kontakt wurde hergestellt. Üblicherweise ist das Metall 19, welches zur Metallisierung eingesetzt wird, Kupfer. Alternativ können auch Aluminium, Nickel oder Nickellegierungen eingesetzt werden. Im Allgemeinen wird für die Metallisierung zunächst stromlos eine Startmetallisierung aus Palladium abgeschieden. Daran anschließend erfolgt eine galvanische Metallabscheidung. Das Metall 19 kann die Form einer Hülse einnehmen oder die Löcher 17 vollständig füllen.

Nach dem Einbringen der Löcher 17 für die Kontaktierung der elektronischen Bauelemente 9 in die leitfähige Folie 1 und der Metallisierung der Löcher 17 wird die leitfähige Schicht 3, wie in Figur 4 dargestellt, strukturiert. Das Strukturieren erfolgt dabei durch ein beliebiges, dem Fachmann bekanntes Verfahren. Geeignete Verfahren sind zum Beispiel Ätzverfahren, Photoresistverfahren, Laserbohrverfahren oder Laserablationsverfahren.

Durch die Strukturierung der leitfähigen Schicht werden die für die Leiterplatte notwendigen Leiterbahnstrukturen 15 erzeugt.

Durch das Einbetten der elektronischen Bauelemente 9 in den Leiterplattenträger 13 wird eine ebene Oberfläche erzielt. Hierdurch ist eine einfache Verarbeitung der Oberfläche möglich.

Selbstverständlich ist es jedoch auch möglich, zuerst die Leiterbahnstruktur 15 aus der leitfähigen Folie 1 auszuarbeiten und daran anschließend die Löcher in die leitfähige Folie 1 einzubringen und zu metallisieren.

In Figur 5 ist eine elektronische Baugruppe 21 dargestellt. Die elektronische Baugruppe 21 umfasst zwei Leiterplatten 23, die wie in Figur 4 dargestellt aufgebaut sind. Auf die Leiterbahnstruktur 15 ist ein Dielektrikum 25 aufgebracht, um eine weitere Leiterbahnstruktur 27 aufzubringen. Als Dielektrikum 25 eignen sich zum Beispiel Epoxidharze oder FR4-Materialien, die aus der Leiterplattentechnik bekannt sind. Das Aufbringen des Dielektrikums 25 erfolgt mit den üblichen, dem Fachmann bekannten Verfahren. So ist es zum Beispiel möglich, das Dielektrikum 25 durch Rakeln, Streichen, Drucken, Auflaminieren, Vorhangguss, Filmcoating, Spray-Coating oder ähnliche Verfahren aufzubringen.

Auf das Dielektrikum 25 wird eine weitere Leiterbahnstruktur 27 aufgebracht. Hierzu ist es möglich, zunächst vollflächig eine leitfähige Schicht aufzutragen, die anschließend strukturiert wird.

Bevorzugt ist es auch möglich, auf die erste Leiterbahnstruktur 15 eine weitere leitfähige Folie 1 aufzutragen und aus der leitfähigen Schicht der zweiten leitfähigen Folie die Leiterbahnstruktur 27 zu strukturieren. Dies erfolgt dann vorzugsweise nach den gleichen Verfahren wie die Strukturierung der leitfähigen Schicht 3 zur Leiterbahnstruktur 15. Nach dem Herstellen der Leiterbahnstruktur 27 können Löcher 29 in das Dielektrikum 25 eingebracht werden, durch welche mittels Metallisierung eine Kontaktierung der Leiterbahnstruktur 27 mit der Leiterbahnstruktur 15 erfolgt. Das Einbringen der Löcher 29 kann selbstverständlich auch vor dem Herstellen der Leiterbahnstruktur 27 erfolgen.

Besonders bevorzugt werden zur Herstellung mehrerer leitfähiger, zu Leiterbahnen strukturierter Schichten zunächst das Dielektrikum 25 und anschließend eine leitfähige Folie auflaminiert. Nach dem Auflaminieren des Dielektrikums 25 und der leitfähigen Folie werden zunächst Löcher eingebracht, die anschließend metallisiert werden, um die leitfähige Folie mit darunterliegenden Schichten elektrisch zu verbinden. Daran anschließend wird aus der leitfähigen Folie eine weitere Leiterbahnstruktur 27 herausgearbeitet.

Um die weitere Leiterbahnstruktur 27 durch möglichst günstige Verfahren herstellen zu können, ist es bevorzugt, dass die isolierende Schicht 5 und die Leiterbahnstruktur 15 vor dem Aufbringen des Dielektrikums 25 aufgespreizt werden. Hierdurch wird die Leiterbahnstruktur vergrößert. Es kann ein weniger präzises Herstellungsverfahren für die weiteren Leiterbahnstrukturen 27 eingesetzt werden. Als Strukturierungsverfahren eignen sich dann zum Beispiel auch photolithographische Verfahren. Hierbei handelt es sich um günstigere Verfahren, so dass die elektronische Baugruppe günstiger hergestellt werden kann.

Um Wärme von den elektronischen Bauelementen 9 abzuführen, ist es möglich, an der den Leiterbahnstrukturen 15, 27 abgewandten Seite der elektronischen Bauelemente 9 Kühlkanäle 31 in den Leiterplattenträger 13 einzubringen. Die Kühlkanäle 31 können mit einem Metallkern 33 verbunden werden. Über den Metallkern 33 und die Kühlkanäle 31 wird Wärme von den elektronischen Bauelementen 9 abgeführt. Das Anbinden der Kühlkanäle 31 an den Metallkern 33 erfolgt im Allgemeinen über eine Rückseitenmetallisierung oder alternative Anbindungen, bei der die Innenwände der Kühlkanäle 31 mit einer Metallschicht versehen werden. Es ist aber auch möglich, die Kühlkanäle 31 vollständig mit einem Metall zu füllen.

Weiterhin ist es auch möglich, zwischen dem Metallkern 33 und den elektronischen Bauelementen 9 Kühlelemente vorzusehen. Auch ist es möglich, den Metallkern 33 so zu gestalten, dass dieser die elektronischen Bauelemente 9 direkt kontaktiert.

Die Verbindung der Leiterplatten 23 erfolgt vorzugsweise ebenfalls mittels eines Laminierprozesses, wie dies bei Leiterplattenherstellungsprozessen üblich ist.

Mit einer Bohrung 35, die durch beide Leiterplatten 23 hindurchführt, lässt sich die Leiterbahnstruktur 15 der einen Leiterplatte 23 mit der Leiterbahnstruktur 27 der zweiten Leiterplatte 23 verbinden. Der elektrische Kontakt erfolgt zum Beispiel durch eine Metallisierung der Wandung der Bohrung 35. Mittels einer Bohrung 37, die auf dem Metallkern 33 endet, kann die Leiterbahnstruktur 15, 27 mit dem Metallkern 33 elektrisch kontaktiert werden. Hierdurch lässt sich zum Beispiel ein Massekontakt realisieren. Auch bei der Bohrung 37 erfolgt der elektrische Kontakt vorzugsweise mittels einer Metallisierung. Die Metallisierung der Bohrungen 35, 37 wird zum Beispiel durch stromlose oder galvanische Metallabscheidung erzeugt. Alternativ ist es aber zum Beispiel auch möglich, einen Draht durch die Bohrungen 35, 37 zu führen.

Bei der in Figur 5 dargestellten Ausführungsform sind bei einer Leiterplatte 23 die elektronischen Bauelemente 9 nicht mit der Polymermasse 11 ummantelt und bei der zweiten Leiterplatte 23, die für die elektronische Baugruppe 21 verwendet wird, sind die elektronischen Bauelemente 9 mit der Polymermasse 11 umschlossen.

Neben der hier dargestellten Ausführungsform, bei der jeweils zwei Leiterbahnstrukturen 15, 27 übereinander angeordnet sind, ist es selbstverständlich auch möglich, dass mehr als zwei Leiterbahnstrukturen auf einer Seite vorgesehen sind. Auch ist es möglich, dass auf der Oberseite und der Unterseite der elektronischen Baugruppe 21 eine unterschiedliche Anzahl an Leiterbahnstrukturen 15, 27 ausgebildet ist.

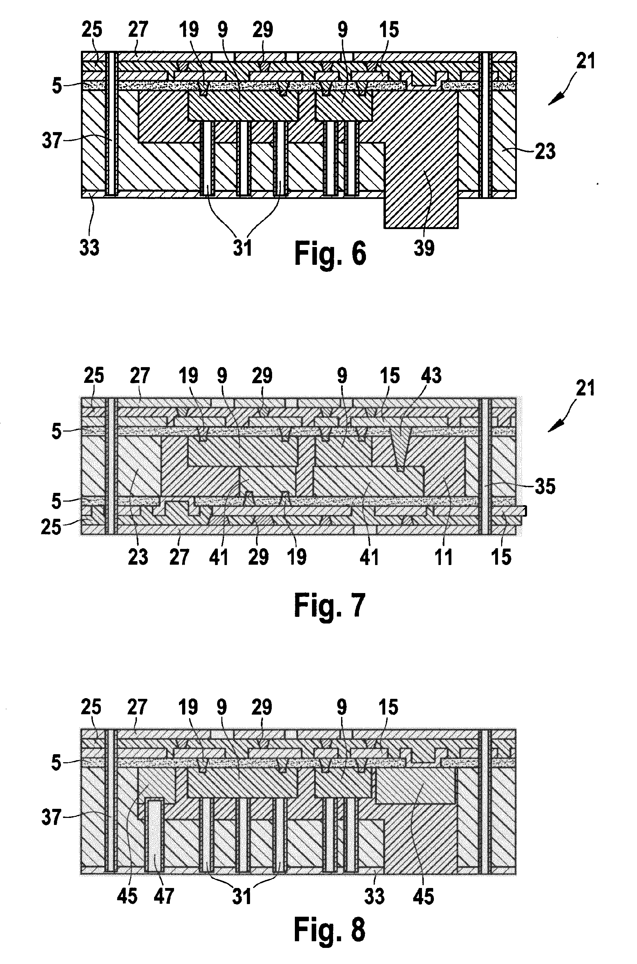

Figur 6 zeigt eine erfindungsgemäß ausgebildete elektronische Baugruppe mit einer mechanischen Einlage.

Die in Figur 6 dargestellte elektronische Baugruppe 21 unterscheidet sich von der in Figur 5 dargestellten elektronischen Baugruppe dadurch, dass die Leiterplatte 23 nur auf einer Seite mit elektronischen Bauelementen 9 und Leiterbahnstrukturen 15, 27 versehen ist. In der Leiterplatte 23 ist weiterhin eine mechanische Einlage 39 ausgebildet. Die mechanische Einlage 39 ist zum Beispiel ein Strömungskanal. Ein solcher wird zum Beispiel benötigt, wenn die elektronische Baugruppe 21 einen Strömungssensor enthält oder ein Strömungssensor ist. Die mechanische Einlage 39 kann aber auch jedes beliebige andere mechanische Bauteil sein, welches benötigt wird, um die elektronische Baugruppe 21 betreiben zu können. Die mechanische Einlage 39 kann weiterhin zum Beispiel ein Gehäuseteil, ein Montageteil, beispielsweise eine mechanische Fixierung z.B. für Schnapp- oder Schraubverbindungen, eine funktionale Struktur wie eine Gasführung, ein Kanal z.B. zur Strahlungs- oder Medienzufuhr oder auch eine 3D-Leiterplatte, z.B. ein MID-Aufbau mit montierten Bauteilen sein.

In Figur 7 ist.eine elektronische Baugruppe 21 in einer weiteren Ausführungsform dargestellt.

Bei der in Figur 7 dargestellten elektronischen Baugruppe 21 sind auf die elektronischen Bauelemente 9 weitere elektronische Bauelemente 41 aufgebracht. Das Aufbringen der elektronischen Bauelemente 41 auf die elektronischen Bauelemente 9 erfolgt zum Beispiel durch Verkleben. Hierzu werden beispielsweise Die-Attach-Filme verwendet. Das Befestigen erfolgt dabei durch ein Verkleben. Die elektronischen Bauelemente 9, 41 sind dabei derart miteinander verbunden, dass die Anschlussseiten jeweils voneinander weg weisen. Die elektronischen Bauelemente 9, 41 sind dann mit Leiterbahnstrukturen 15, 27 verbunden, die sich jeweils auf der Oberseite beziehungsweise Unterseite der elektronischen Baugruppe 21 befinden. Dabei weisen jeweils Anschlüsse der elektronischen Bauelemente 9, 41 zu den Leiterbahnstrukturen 15, 27. Es ist jedoch auch möglich, dass ein elektronisches Bauelement 9, 41 mit der Leiterbahnstruktur 15, 27 verbunden ist, welche auf der Seite angeordnet ist, auf der sich die jeweils anderen Bauelemente 9, 41 befinden. Hierzu ist eine Kontaktierung 43 an einem elektronischen Bauelement 9 zum elektronischen Bauelement 41 vorbei durch die Leiterplatte 23 erforderlich. Die Bauelemente 9, 41 können, wie in Figur 7 dargestellt, von einer Polymermasse 11 ummantelt sein. Alternativ ist es auch möglich, dass die Bauelemente 9, 41 direkt in den Leiterplattenträger eingelassen sind, ohne zuvor von der Polymermasse 11 ummantelt worden zu sein.

In Figur 8 ist eine elektronische Baugruppe 21 in noch einer weiteren Ausführungsform dargestellt.

Die in Figur 8 dargestellte Ausführungsform unterscheidet sich von der in Figur 6 dargestellten Ausführungsform dadurch, dass zur besseren Wärmeverteilung oder Wärmeabfuhr aus dem elektronischen Bauelement in unmittelbarer Nähe der elektronischen Bauelemente 9 weitere Metallkerne 45 vorgesehen sind. Die Metallkerne 45 sind dabei von der Polymermasse 11 mit umschlossen. Die Metallkerne 45 sind zum Beispiel beim Bestücken der leitfäliegen Folie 1 mit auf die isolierende Schicht 5 zusammen mit den elektronischen Bauelementen 9 aufgebracht worden. Die Wärmeabfuhr von den Metallkernen 45 erfolgt zum Beispiel über Wärmebrücken 47. Diese sind beispielsweise in Form einer Bohrung mit einer Oberflächenmetallisierung ausgeführt. Auch können die Wärmebrücken 47 vollständig mit Metall oder einem anderen gut wärmeleitfähigen Material befüllt sein. Die Wärmebrücken 47 verbinden den Metallkern 45 mit dem Metallkern 33, welcher Wärme an die Umgebung abgeben kann.

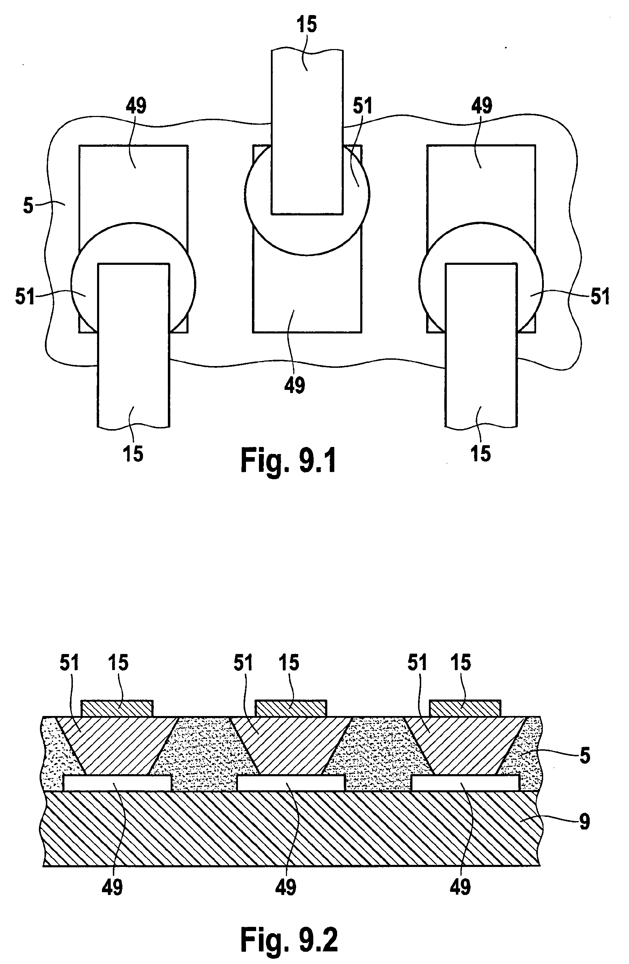

In den Figuren 9.1 und 9.2 ist exemplarisch eine versetzte Ankontaktierung dargestellt, wie sie vorteilhafterweise durchgeführt wird, wenn die isolierende Schicht 5 und die Leiterbahnstruktur 15 vor Aufbringen weiterer Leiterbahnstrukturen aufgespreizt werden. Figur 9.1 zeigt dabei eine Draufsicht und Figur 9.2 eine Schnittdarstellung. Das elektronische Bauteil 9, zum Beispiel ein IC, weist rechteckförmige Kontaktflächen 49 auf. Diese werden mit Duchkontaktierungen 51 durch die isolierende Schicht 5 kontaktiert. Hierdurch lässt sich das elektronische Bauteil 9 mit der Leiterbahnstruktur 15 verbinden.

Zur Aufspreizung nimmt der Durchmesser der Durchkontaktierungen 51 vom elektronischen Bauteil zur Oberseite der isolierenden Schicht 5 zu. Durch die versetzte Anordnung der Durchkontaktierungen 51 vergrößert sich der Mittenabstand der Durchkontaktierungen 51 im Vergleich zu einer Anordnung in Reihe. Hierdurch wird die Fertigung insbesondere bei kleinen Kontaktmittenabständen, z.B. kleiner als 150 µm erleichtert.

Durch eine geeignete Leitungsführung in der nächsten Lage des Substrates lassen sich die Abstände zwischen den Leiterbahnen der Leiterbahnstruktur 15 weiter vergrößern und so die Verfahren zur Kontaktierung weiter vereinfachen.

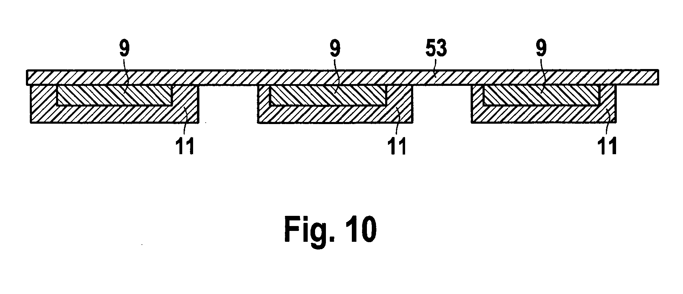

Ein Vorteil des erfindungsgemäßen Verfahrens ist es, dass mit diesem Verfahren auch eine komplette Rolle zu Rolle-Fertigung in allen Arbeitsgängen möglich ist. Hierdurch lassen sich Leiterplatten in einer durchgängigen Linie fertigen. Hierzu ist es zum Beispiel auch möglich, flexible Leiterplattenmaterialien zu verwenden. Dies ist exemplarisch in Figur 10 dargestellt.

Zur Herstellung von flexiblen Leiterplatten werden zum Beispiel elektronische Bauelemente 9 auf einem flexiblen Schaltungsträger 53 befestigt. Der flexible Schaltungsträger 53 umfasst im Allgemeinen eine isolierende Schicht und mindestens eine Leiterbahnstruktur, die hier jedoch nicht dargestellt sind. Zum Schutz des elektronischen Bauteiles 9 ist es möglich, dieses mit einer Polymermasse 11 zu umschließen.

## Patentansprüche

1. Verfahren zur Herstellung einer elektronischen Baugruppe (21), umfassend mindestens ein elektronisches Bauelement (9), das auf einer Leiterplatte (23) befestigt ist, sowie mindestens eine Leiterbahnstruktur (15, 27), mit der das mindestens eine elektronische Bauelement (9) kontaktiert wird, folgende Schritte umfassend:
(a) Befestigen des mindestens einen elektronischen Bauelementes (9) auf einer isolierenden Schicht (5) einer leitfähigen Folie (1), wobei die aktive Seite des mindestens einen elektronischen Bauelements (9) in Richtung der leitfähigen Folie (1) weist,
(b) Auflaminieren der leitfähigen Folie (1) mit dem mindestens einen daran befestigten elektronischen Bauelement (9) auf einen Leiterplattenträger (13), wobei das mindestens eine elektronische Bauelement (9) in Richtung des Leiterplattenträgers (13) weist,
(c) Ausbilden einer Leiterbahnstruktur (15) durch Strukturieren der leitfähigen Folie (1) und Ankontaktieren des mindestens einen elektronischen Bauelements (9),
**dadurch gekennzeichnet, dass** erste elektronische Bauteile (9) vorgesehen sind, welche für eine Ankontaktierung mit der Leiterbahnstruktur (15) kleine Durchgänge (17) in der isolierenden Schicht (5) benötigen, und zweite elektronische Bauteile (9) vorgesehen sind, welche größere Durchgänge (17) in der isolierenden Schicht (5) benötigen, und die ersten elektronischen Bauteile (9) weiter in die isolierende Schicht (5) eingedrückt werden als die zweiten elektronischen Bauteile (9).

2. Verfahren nach Anspruch 1, **dadurch gekennzeichnet, dass** das mindestens eine elektronische Bauelement (9) nach dem Befestigen auf der leitfähigen Folie (1) von einer Polymermasse (11) umschlossen wird.

3. Verfahren nach Anspruch 2, **dadurch gekennzeichnet, dass** die Polymermasse (11) eine flüssige Harzmatrix aufweist, mit der das mindestens eine elektronische Bauelement (9) umgossen wird, und die anschließend ausgehärtet wird.

4. Verfahren nach einem der Ansprüche 1 bis 3, **dadurch gekennzeichnet, dass** die isolierende Schicht (5) der leitfähigen Folie (1) mindestens ein Flüssigkristall-Polymer enthält.

5. Verfahren nach einem der Ansprüche 1 bis 4, **dadurch gekennzeichnet, dass** die elektronischen Bauteile (9) so weit in die isolierende Schicht (5) der leitfähigen Folie (1) eingedrückt werden, dass die Durchkontaktierungen (19), mit denen die elektronischen Bauteile (9) an die Leiterbahnstruktur (15) angeschlossen werden, ein Aspektverhältnis aufweisen, das im Bereich von 1 bis 3 liegt.

6. Verfahren nach einem der Ansprüche 1 bis 5, **dadurch gekennzeichnet, dass** die isolierende Schicht (5) eine Klebeschicht ist, auf welche das mindestens eine elektronische Bauteil (9) aufgeklebt wird.

7. Verfahren nach einem der Ansprüche 1 bis 6, **dadurch gekennzeichnet, dass** vor dem Befestigen des mindestens einen elektronischen Bauelementes (9) auf die leitfähige Folie (1) in Schritt (a) Justagemarken (7) in die leitfähige Folie (1) eingebracht werden.

8. Verfahren nach einem der Ansprüche 1 bis 7, **dadurch gekennzeichnet, dass** auf die in Schritt (c) ausgebildete Leiterbahnstruktur (15) mindestens eine weitere Lage, die eine Leiterbahnstruktur (27) enthält, aufgebracht wird.

9. Verfahren nach einem der Ansprüche 1 bis 8, **dadurch gekennzeichnet, dass** das mindestens eine elektronische Bauteil (9) auf der von der Leiterbahnstruktur (15) wegweisenden Seite mit einem Metallkern (33) kontaktiert wird.

10. Verfahren nach Anspruch 9, **dadurch gekennzeichnet, dass** der Metallkern (33) im Leiterplattenträger (13) integriert ist.

11. Verfahren nach einem der Ansprüche 1 bis 10, **dadurch gekennzeichnet, dass** in die leitfähige Folie (1) an den Positionen, an denen das mindestens eine elektronische Bauelement (9) mit der leitfähigen Folie (1) elektrisch kontaktiert werden soll, Löcher (17) eingebracht werden.

12. Verfahren nach Anspruch 11, **dadurch gekennzeichnet, dass** die Löcher (17) zur Kontaktierung der Leiterbahnstruktur (15) mit dem mindestens einen elektronischen Bauelement (9) metallisiert werden.

13. Verfahren nach Anspruch 12, **dadurch gekennzeichnet, dass** das Aufspreizen der Leiterbahnstruktur (15) vor dem Aufbringen einer weiteren Leiterbahnstruktur (27) nach dem Metallisieren der Löcher (17) in der ersten Leiterbahnstruktur (15) und der isolierenden Schicht (5) erfolgt.

14. Verfahren nach einem der Ansprüche 1 bis 13, **dadurch gekennzeichnet, dass** die leitfähige Folie (1) eine leitfähige Schicht (3) aufweist, die Kupfer, Aluminium, Nickel oder nickelhaltige Legierungen enthält.

15. Verfahren nach Anspruch 12, **dadurch gekennzeichnet, dass** die Metallisierung der Löcher (17, 29) mit Kupfer, Aluminium, Nickel oder einer nickelhaltigen Legierung erfolgt.

16. Verfahren nach einem der Ansprüche 1 bis 15, **dadurch gekennzeichnet, dass** das Befestigen des mindestens einen elektronischen Bauelementes (9) durch Aufkleben auf die isolierende Schicht (5) der leitfähigen Folie (1) mit einem elektrisch nicht leitfähigen Klebstoff erfolgt.

## Claims

1. Method for producing an electronic assembly (21), comprising at least one electronic component (9), which is fastened on a circuit board (23), and at least one strip conductor pattern (15, 27), with which the at least one electronic component (9) is brought into contact, comprising the following steps:
(a) fastening the at least one electronic component (9) on an insulating layer (5) of a conductive film (1), the active side of the at least one electronic component (9) facing in the direction of the conductive film (1),
(b) laminating the conductive film (1) with the at least one electronic component (9) fastened thereto onto a circuit board carrier (13), the at least one electronic component (9) facing in the direction of the circuit board carrier (13),
(c) forming a strip conductor pattern (15) by patterning the conductive film (1) and establishing contact with the at least one electronic component (9),
**characterized in that** first electronic components (9) are provided, requiring small passages (17) in the insulating layer (5) for establishing contact with the strip conductor pattern (15), and second electronic components (9) are provided, requiring larger passages (17) in the insulating layer (5), and the first electronic components (9) are pressed further into the insulating layer (5) than the second electronic components (9).

2. Method according to Claim 1, **characterized in that** the at least one electronic component (9) is enclosed by a polymer compound (11) after being fastened on the conductive film (1).

3. Method according to Claim 2, **characterized in that** the polymer compound (11) has a liquid resin matrix, with which the at least one electronic component (9) is enclosed, and which is subsequently cured.

4. Method according to one of Claims 1 to 3, **characterized in that** the insulating layer (5) of the conductive film (1) contains at least one liquid-crystal polymer.

5. Method according to one of Claims 1 to 4, **characterized in that** the electronic components (9) are pressed so far into the insulating layer (5) of the conductive film (1) that the feedthroughs (19) by which the electronic components (9) are connected to the strip conductor pattern (15) have an aspect ratio that lies in the range from 1 to 3.

6. Method according to one of Claims 1 to 5, **characterized in that** the insulating layer (5) is an adhesive layer, onto which the at least one electronic component (9) is adhesively attached.

7. Method according to one of Claims 1 to 6, **characterized in that**, before the fastening of the at least one electronic component (9) on the conductive film (1) in step (a), adjusting marks (7) are introduced into the conductive film (1).

8. Method according to one of Claims 1 to 7, **characterized in that** at least one further layer that contains a strip conductor pattern (27) is applied to the strip conductor pattern (15) formed in step (c).

9. Method according to one of Claims 1 to 8, **characterized in that** the at least one electronic component (9) is brought into contact with a metal core (33) on the side facing away from the strip conductor pattern (15).

10. Method according to Claim 9, **characterized in that** the metal core (33) is integrated in the circuit board carrier (13).

11. Method according to one of Claims 1 to 10, **characterized in that** holes (17) are introduced into the conductive film (1) at the positions at which the electrical contact is intended to be established between the at least one electronic component (9) and the conductive film (1).

12. Method according to Claim 11, **characterized in that** the holes (17) for establishing the contact between the strip conductor pattern (15) and the at least one electronic component (9) are metallized.

13. Method according to Claim 12, **characterized in that** the spreading open of the strip conductor pattern (15) before the application of a further strip conductor pattern (27) is performed after the metallizing of the holes (17) in the first strip conductor pattern (15) and the insulating layer (5).

14. Method according to one of Claims 1 to 13, **characterized in that** the conductive film (1) has a conductive layer (3), which contains copper, aluminium, nickel or nickel-containing alloys.

15. Method according to Claim 12, **characterized in that** the metallization of the holes (17, 29) is performed with copper, aluminium, nickel or a nickel-containing alloy.

16. Method according to one of Claims 1 to 15, **characterized in that** the fastening of the at least one electronic component (9) by adhesive attachment onto the insulating layer (5) of the conductive film (1) is performed with an electrically nonconductive adhesive.

## Revendications

1. Procédé de fabrication d'un module électronique (21) comprenant au moins un composant électronique (9) fixé sur une carte de circuit (23) ainsi qu'au moins une structure (15, 27) de pistes conductrices en contact avec le ou les composants électroniques (9), le procédé comportant les étapes suivantes :
(a) fixation du ou des composants électroniques (9) sur une couche isolante (5) d'un film conducteur (1), le côté actif du ou des composants électroniques (9) étant orienté en direction du film conducteur (1),
(b) stratification du film conducteur (1) sur lequel sont fixés le ou les composants électroniques (9) sur un support (13) de carte de circuit, le ou les composants électroniques (9) étant orientés en direction du support (13) de carte de circuit,
(c) formation d'une structure (15) de pistes conductrices par structuration du film conducteur (1) et mise en contact du film avec le ou les composants électroniques (9),
**caractérisé en ce que**
des premiers composants électroniques (9) qui ne nécessitent pas de passage (17) à travers la couche isolante (5) pour établir le contact avec la structure (15) de piste conductrice et des deuxièmes composants électroniques (9) qui nécessitent de plus grands passages (17) à travers la couche isolante (5) sont prévus, les premiers composants électroniques (9) étant enfoncés davantage dans la couche isolante (5) que les deuxièmes composants électroniques (9).

2. Procédé selon la revendication 1, **caractérisé en ce que** le ou les composants électroniques (9) sont englobés dans une pâte polymère (11) après avoir été fixés sur le film conducteur (1).

3. Procédé selon la revendication 2, **caractérisé en ce que** la pâte polymère (11) présente une matrice liquide de résine dans laquelle le ou les composants électroniques (9) sont englobés, la matrice étant ensuite durcie.

4. Procédé selon l'une des revendications 1 à 3, **caractérisé en ce que** la couche isolante (5) du film conducteur (1) contient au moins un polymère à cristaux liquides.

5. Procédé selon l'une des revendications 1 à 4, **caractérisé en ce que** les composants électroniques (9) sont enfoncés dans la couche isolante (5) du film conducteur (1) suffisamment profondément pour que les passages de contact (19) par lesquels les composants électroniques (9) sont raccordés à la structure (15) de pistes conductrices présentent un rapport d'allongement compris dans la plage de 1 à 3.

6. Procédé selon l'une des revendications 1 à 5, **caractérisé en ce que** la couche isolante (5) est une couche adhésive sur laquelle le ou les composants électroniques (9) sont collés.

7. Procédé selon l'une des revendications 1 à 6, **caractérisé en ce que** des repères d'ajustement (7) sont ménagés dans le film conducteur (1) avant la fixation du ou des composants électroniques (9) sur le film conducteur (1) à l'étape (a).

8. Procédé selon l'une des revendications 1 à 7, **caractérisé en ce qu'**au moins une autre couche qui contient une structure (27) de pistes conductrices est appliquée sur la structure (15) de pistes conductrices formées à l'étape (c).

9. Procédé selon l'une des revendications 1 à 8, **caractérisé en ce que** le ou les composants électroniques (9) sont mis en contact avec une âme métallique (33) placée sur le côté non tourné vers la structure (15) de pistes conductrices.

10. Procédé selon la revendication 9, **caractérisé en ce que** l'âme métallique (33) est intégrée dans le support (13) de carte de circuit.

11. Procédé selon l'une des revendications 1 à 10, **caractérisé en ce que** des trous (17) sont ménagés dans le film conducteur (1) aux positions dans lesquelles le ou les composants électroniques (9) doivent être mis en contact électrique avec le film conducteur (1).

12. Procédé selon la revendication 11, **caractérisé en ce que** les trous (17) destinés à assurer le contact de la structure (15) de pistes conductrices avec le ou les composants électroniques (9) sont métallisés.

13. Procédé selon la revendication 12, **caractérisé en ce que** l'étalement de la structure (15) de pistes conductrices s'effectue avec l'application d'une autre structure (27) de pistes conductrices après la métallisation des trous (17) ménagés dans la première structure (15) de pistes conductrices et la couche isolante (5).

14. Procédé selon l'une des revendications 1 à 13, **caractérisé en ce que** le film conducteur (1) présente une couche conductrice (3) qui contient du cuivre, de l'aluminium, du nickel ou des alliages contenant du nickel.

15. Procédé selon la revendication 12, **caractérisé en ce que** la métallisation des trous (17, 29) s'effectue à l'aide de cuivre, d'aluminium, de nickel ou d'un alliage contenant du nickel.

16. Procédé selon l'une des revendications 1 à 15, **caractérisé en ce que** la fixation du ou des composants électroniques (9) s'effectue par collage sur la couche isolante (5) du film conducteur (1) à l'aide d'un adhésif électriquement non conducteur.
